# EUROPEAN PATENT APPLICATION

(11) **EP 3 799 117 A1**
(43) Date of publication of application: **31.03.2021**
(21) Application number: 19920673.1
(22) Date of filing: 15.08.2019
(51) Int. Cl.: H01L 23/48

(54) **CHIP INTERCONNECTION STRUCTURE, CHIPS AND CHIP INTERCONNECTION METHOD**

(71) Applicant: Shenzhen Goodix Technology Co., Ltd., Futian Free Trade Zone Shenzhen, Guangdong 548045 (CN)
(72) Inventor: The designation of the inventor has not yet been filed
(74) Representative: Elzaburu S.L.P.
(86) International application number: PCT/CN2019/100732
(87) International publication number: WO 2021/026865

(57) **Abstract**

The present application provides a chip interconnection structure, a chip and a chip interconnection method. The chip interconnection structure includes a first chip and at least one second chip, where a transfer surface of the first chip and a transfer surface of the second chip are disposed oppositely, at least one conductive component is further provided between the second chip and the first chip, each conductive component includes at least one conductive member, and the conductive member is connected between a pad of the second chip and a pad of the first chip. The chip interconnection structure provided by the present application can allow two or more than two chips to be interconnected and to communicate at a high speed.

## Description

### TECHNICAL FIELD

The present application relates to the field of semiconductor manufacturing technology, and in particular to a chip interconnection structure, a chip and a chip interconnection method.

### BACKGROUND

With the development of semiconductor technology, the size of chips tends to be miniaturized, and requirements on communication speed of the chips become higher and higher with the development of science and technology.

At present, in traditional packaging methods, two or more chips are connected relying on wire bonding and a circuit board substrate so as to realize interconnections of pins between the chips, thereby achieving communication. Wire bonding, called pressure welding, refers to achieving connections of interconnection wires inside solid circuits in microelectronic devices (that is, connections between the chips and the circuits or lead frames) by utilizing hot pressing or ultrasonic energy using metal wires, which is commonly used in surface packaging processes.

However, when the traditional packaging methods described above are used to realize the interconnections between the two or more chips, since leads and substrate windings used when interconnecting the two or more chips are too long, resistances increase, which results in a bottleneck of communication speed, such as a drop in the communication speed. If there is a need to maintain the communication speed, then the power needs to be increased. If the two or more chips that need to be interconnected to communicate are directly made on the same wafer, then the production cost will increase greatly. Therefore, a chip interconnection technology that can realize high speed communication is needed.

### SUMMARY

The present application provides a chip interconnection structure, a chip and a chip interconnection method, which could allow two or more than two chips to be interconnected and to communicate at a high speed.

In a first aspect, the present application provides a chip interconnection structure, including a first chip and at least one second chip, where a transfer surface of the first chip and a transfer surface of the second chip are disposed oppositely, at least one conductive component is further provided between the second chip and the first chip, each conductive component includes at least one conductive member, and the conductive member is connected between a pad of the second chip and a pad of the first chip.

In the chip interconnection structure described above, optionally, each conductive component includes at least two conductive members connected in sequence.

In the chip interconnection structure described above, optionally, each conductive component includes a first conductive member and a second conductive member, a first terminal of the first conductive member is connected to the pad of the first chip, a second terminal of the first conductive member and a first terminal of the second conductive member are butted to each other, and a second terminal of the second conductive member is connected to the pad of the second chip.

In the chip interconnection structure described above, optionally, the conductive member is a metal member.

In the chip interconnection structure described above, optionally, the first conductive member and the second conductive member are connected through welding, or the first conductive member and the second conductive member are connected through conductive adhesive.

In the chip interconnection structure described above, optionally, a material of the conductive member is one or two of copper, silver, tin, gold and aluminum.

In the chip interconnection structure described above, optionally, the first conductive member and the second conductive member are conductive metal capable of forming eutectic.

In the chip interconnection structure described above, optionally, when the first conductive member and the second conductive member are connected through welding, a junction between the first conductive member and the second conductive member has an eutectic layer.

In any one of the chip interconnection structures described above, optionally, the conductive member and the pad have an integral structure.

In the chip interconnection structure described above, optionally, the second terminal of the first conductive member and the first terminal of the second conductive member have a same cross-section shape.

In the chip interconnection structure described above, optionally, the conductive member is vertically disposed between the pad of the second chip and the pad of the first chip.

In the chip interconnection structure described above, optionally, the conductive member is a cylinder or a prism.

In the chip interconnection structure described above, optionally, the number of the second chip is at least two, and the second chips are disposed at a same side of the first chip, or the second chips are disposed at front and back sides of the first chip.

In any one of the chip interconnection structures described above, optionally, the first chip and the second chip are both a single bare chip.

In the chip interconnection structure described above, optionally, the first chip includes a first wafer, a first functional layer is provided on the first wafer, a first pad is provided on the first functional layer, and a second pad interconnected with an external circuit is further provided on the first functional layer; and
the second chip includes a second wafer, a second functional layer is provided on the second wafer, a third pad is provided on the second functional layer, and the conductive member is connected between the third pad and the first pad.

In the chip interconnection structure described above, optionally, the first chip further includes a first insulating layer, a first window structure communicating with the first pad is provided on the first insulating layer; the second chip further includes a second insulating layer, a second window structure communicating with the third pad is provided on the second insulating layer; and the conductive member is located between the first window structure and the second window structure.

In the chip interconnection structure described above, optionally, a sealing layer for sealing the conductive component is further provided between the first chip and the second chip.

In the chip interconnection structure described above, optionally, the pad of the first chip is disposed on the transfer surface of the first chip, the pad of the second chip is disposed on the transfer surface of the second chip, and the pad of the first chip and the corresponding pad of the second chip are interconnected through the one conductive component.

In a second aspect, the present application provides a chip, which includes any one of the chip interconnection structures described above.

In a third aspect, the present application provides a chip interconnection method, applied to an interconnection of a first chip and at least one second chip, including:
forming a conductive member on at least one of a first wafer and a second wafer, where the first wafer is a wafer where the first chip is located, the second wafer is a wafer where the second chip is located, and a position of the conductive member corresponds to a position of a pad;
obtaining the first chip and the second chip on the first wafer and the second wafer, respectively; and
butting the first chip and the second chip, and connecting a pad of the first chip and a pad of the second chip using the conductive member.

In the chip interconnection method described above, optionally, the forming the conductive member on the at least one of the first wafer and the second wafer specifically includes:
forming the conductive member on the first wafer and the second wafer, respectively.

In the chip interconnection method described above, optionally, a formation manner of the conductive member includes one or more of the following: sputtering, evaporating, electroplating, electroless-plating, and pasting a conductive film.

In the chip interconnection method described above, optionally, the obtaining the first chip and the second chip on the first wafer and the second wafer, respectively, specifically includes:

cutting out the first chip from the first wafer, and cutting out the second chip from the second wafer, where the first chip and the second chip are both a single bare chip.

In the chip interconnection method described above, optionally, the connecting the pad of the first chip and the pad of the second chip using the conductive member specifically includes:
connecting the conductive member on the first chip and/or the conductive member on the second chip by welding or laminating, so that the conductive member connects the pad of the first chip and the pad of the second chip.

The chip interconnection method described above, optionally, before the step of forming the conductive member on the at least one of the first wafer and the second wafer, further including:
if there are insulating layers on surfaces of the first wafer and the second wafer, providing a first window structure communicating with the pad of the first wafer on an insulating layer of the first wafer, and providing a second window structure communicating with the pad of the second wafer on an insulating layer of the second wafer; and
if there is no insulating layer on the surfaces of the first wafer and the second wafer, forming the insulating layers on the surfaces of the first wafer and the second wafer, respectively, providing the first window structure communicating with the pad of the first wafer on the insulating layer of the first wafer, and providing the second window structure communicating with the pad of the second wafer on the insulating layer of the second wafer.

In the chip interconnection method described above, optionally, after connecting the pad of the first chip and the pad of the second chip using the conductive member, further including:
forming a sealing layer between the first chip and the second chip.

The present application provides a chip interconnection structure, a chip and a chip interconnection method. The chip interconnection structure includes the first chip and the at least one second chip, where the transfer surface of the first chip and the transfer surface of the second chip are disposed oppositely, the at least one conductive component is further provided between the second chip and the first chip, each conductive component includes at least one conductive member, and the conductive member is connected between the pad of the second chip and the pad of the first chip. The present application connects the pad of the first chip and the pad of the second chip through the conductive member, so that the leads when interconnecting at least more than two chips are shortest, thereby reducing the power dissipation when the chips are working, further realizing high speed communication of the chips. Therefore, the chip interconnection structure, chip, and interconnection method provided by the present application realizes that two or more than two chips are interconnected, and can achieve a purpose of high speed communication of the interconnected chips.

### BRIEF DESCRIPTION OF DRAWINGS

In order to more clearly illustrate the technical solutions in embodiments of the present application or the prior art, the drawings needed to be used in the description of the embodiments or the prior art will be briefly described below. Obviously, the drawings in the following description are some embodiments of the present application, for those ordinary skilled in the art, other drawings can be obtained according to these drawings without any creative efforts.
FIG. 1 is a schematic structural diagram of a chip interconnection structure according to Embodiment 1 of the present application;
FIG. 2 is a structural schematic diagram of another chip interconnection structure according to Embodiment 1 of the present application;
FIG. 3 is a schematic flowchart of an interconnection method according to Embodiment 6 of the present application;
FIG. 4 is a schematic structural diagram of a first wafer according to Embodiment 6 of the present application;
FIG. 5 is a schematic structural diagram of a second wafer according to Embodiment 6 of the present application;
FIG. 6 is a schematic structural diagram of a first chip according to Embodiment 6 of the present application; and
FIG. 7 is a schematic structural diagram of a second chip according to Embodiment 6 of the present application.

### Description of drawing identifications:

1- First chip;
101-First conductive member;
102-First wafer;
103-First functional layer;
104-First insulating layer;
105-First pad;
106-Second pad;
107-First window structure;
2- Second chip;
201-Second conductive member;
202-Second wafer;
203-Second functional layer;
204-Second insulating layer;
205-Third pad;
206-Second window structure;
3- Sealing member;
4- Eutectic layer;
5- Conductive adhesive.

### DESCRIPTION OF EMBODIMENTS

In order to make the objects, technical solutions and advantages of embodiments of the present application more clear, the technical solutions in the embodiments of the present application will be clearly and completely described in combination with the drawings in the embodiments of the present application. Obviously, the described embodiments are part of the embodiments of the present application, but not all of the embodiments. Based on the embodiments of the present application, all other embodiments obtained by those of ordinary skill in the art without creative efforts are within the protection scope of the present application.

At present, in traditional packaging methods, two or more chips are connected relying on wire bonding and a circuit board substrate so as to realize interconnections of pins between the chips, thereby achieving communication. With the development of science and technology, requirements on communication speed of the chips become higher and higher. Therefore, it is necessary to interconnect the pins between the chips without reducing the communication speed of the chips. However, when the traditional packaging methods described above are used to realize the interconnections between two or more chips, the communication speed will be reduced. If there is a need to maintain the communication speed of the chips, then the power needs to be increased. However, if the two or more chips that need to be interconnected to communicate are directly made on the same wafer, then the production cost will increase greatly. In order to realize that the chips have a normal communication speed when being interconnected, the present application provides a chip interconnection structure, a chip and an interconnection method.

### Embodiment 1

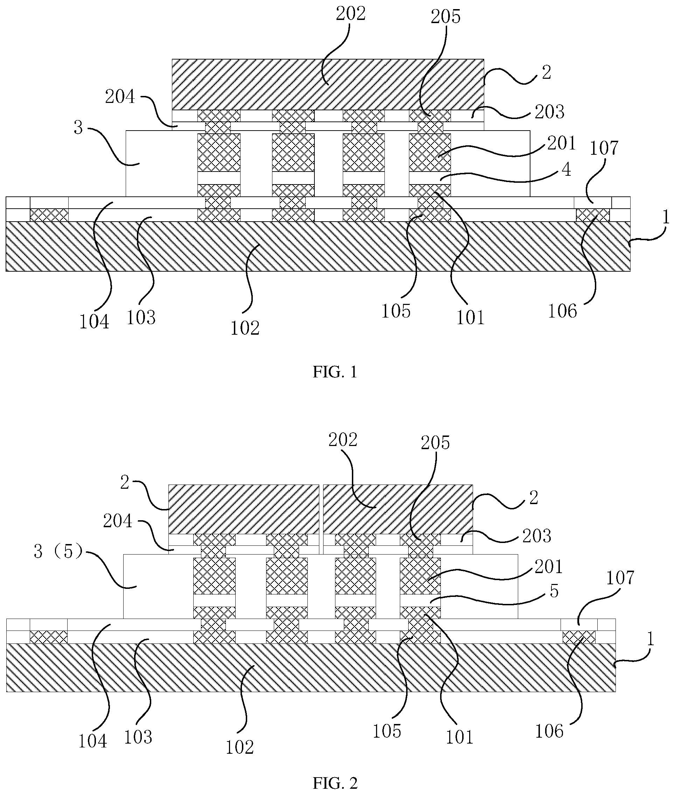

FIG. 1 is a schematic structural diagram of a chip interconnection structure according to Embodiment 1 of the present application, and FIG. 2 is a schematic structural diagram of another chip interconnection structure according to Embodiment 1 of the present application.

The chip interconnection structure provided by this embodiment can be used for interconnections between chips in the field of semiconductor technology, and is especially applied to interconnections between chips that require interconnection and communication. The chip interconnection structure provided by this embodiment realizes that two or more than two chips are interconnected, and can achieve a purpose of high speed communication of the interconnected chips, which solves the technical problem that the communication speed drops when the chips are interconnected in the prior art.

As shown in FIG. 1 and FIG. 2, the chip interconnection structure includes: a first chip 1 and at least one second chip 2. A transfer surface of the first chip 1 and a transfer surface of the second chip 2 are disposed oppositely, and at least one conductive component is further provided between the second chip 2 and the first chip 1. Each conductive component includes at least one conductive member, and the conductive member is connected between a pad of the second chip 2 and a pad of the first chip 1.

In this embodiment, the first chip 1 and the second chip 2 may be any chip that needs to be interconnected and to communicate. The first chip 1 and the second chip 2 in this embodiment may be a microcontroller unit (Microcontroller Unit, MCU) chip and a Flash chip. The first chip 1 and the second chip 2 may also be both memory chips, such as XROM chips. That is, the first chip 1 and the second chip 2 are not specifically limited in this embodiment. The first chip 1 and the second chip 2 may be a logic chip, a memory chip, an image chip, or a control chip. In this embodiment, it is only necessary to ensure that the first chip 1 and the second chip 2 are any chip that needs to be interconnected to communicate.

In this embodiment, the transfer surface of the first chip 1 is a surface, on which a pad is provided, of the first chip 1, and the transfer surface of the second chip 2 is a surface, on which a pad is provided, of the second chip 2. In this embodiment, the transfer surface of the first chip 1 and the transfer surface of the second chip 2 are disposed oppositely. That is, when the first chip 1 and the second chip 2 are interconnected, the second chip 2 is reversely connected to the first chip 1, so that the pad of the first chip 1 and the pad of the second chip 2 are disposed oppositely, so as to make a lead used when interconnecting the first chip 1 and the second chip 2 as short as possible.

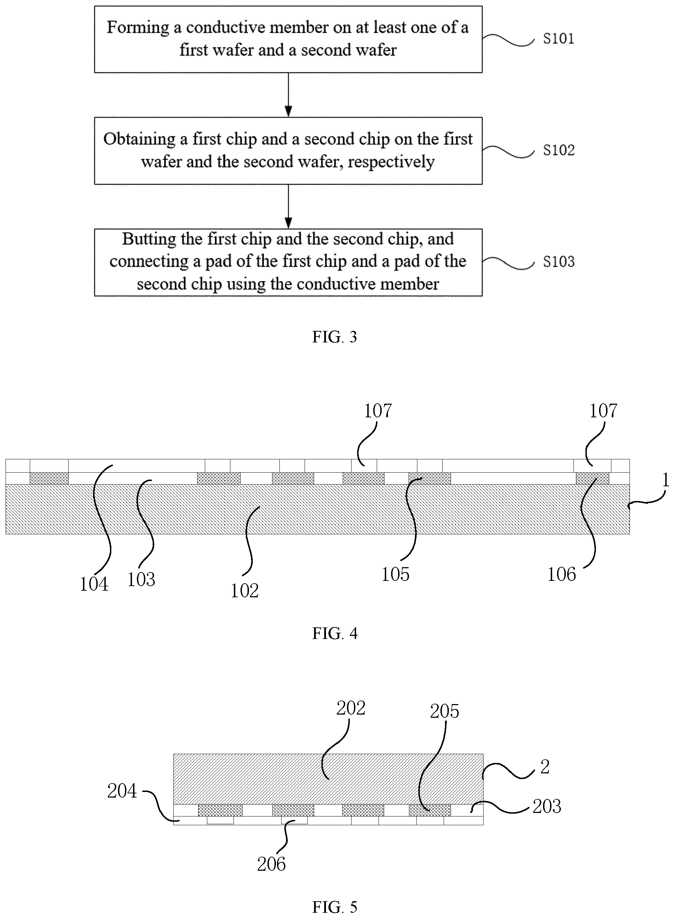

It should be noted that, in this embodiment, as shown in FIG. 1 and FIG. 3, since there is a need to interconnect at least one second chip 2 and the first chip 1, projected area of the first chip 1 on the at least one second chip 2 needs to be greater than or equal to total area of the second chip 2. That is, when two or more than two second chips 2 are interconnected to the first chip 1, the projected area of the first chip 1 on the second chips 2 needs to be greater than or equal to the total area of all the second chips 2 interconnected to the first chip 1. In this embodiment, area size of the first chip 1 and the second chips 2 is not further limited in this embodiment.

In this embodiment, as shown in FIG. 1, the conductive member may be conductive metal. In this embodiment, each conductive component includes at least one conductive member, and at least one conductive member is provided between the first chip 1 and the second chip 2. That is to say, at least one or more conductive members are included between the first chip 1 and the second chip 2, and the first chip 1 and the second chip 2 can be electrically conducted by connecting the conductive member between the pad of the second chip 2 and the pad of the first chip 1, thereby realizing a communication between the first chip 1 and the second chip 2. Moreover, compared with the manner of connecting two or more chips by relying on wire bonding and a circuit board substrate to realize interconnections of pins between the chips in the prior art, an arrangement of the conductive member without wire bonding and substrate winding greatly shortens leads used when interconnecting the first chip 1 and the second chip 2, thereby reducing the power dissipation when the chips are working, and realizing the high speed communication of the chips. Moreover, compared with directly making two or more chips that need to be interconnected and to communicate on the same wafer in the prior art, the interconnection structure of this embodiment is simple and easy to operate without introducing complicated processes, which can greatly reduce the production cost.

In this embodiment, the conductive member and the pad have an integral structure. In this embodiment, the conductive member and the pad of the first chip 1 may have an integral structure, which is connected to the pad of the second chip 2 through the conductive member. The conductive member and the pad of the second chip 2 may have an integral structure, which is connected to the pad of the first chip 1 through the conductive member. That is, in this embodiment, the interconnection and communication between the first chip 1 and the second chip 2 can be realized no matter what manner is employed.

It should be noted that, in this embodiment, the pads on the first chip 1 and the second chip 2 may be metal pads or other pads that can realize surface mount assembly for the first chip 1 and the second chip 2. The pads are as in the prior art, and the specific material of the pads used in this embodiment is not further limited in this embodiment.

It should be noted that, in this embodiment, wafers where the first chip 1 and the second chip 2 are respectively located are both provided with pads before they leave the factory, and surfaces of the wafers have their self-contained insulating layers. When the self-contained insulating layers can meet insulation standards and protection standards theoretically required to be met in the prior art, there is no need to process insulating layers of the first chip 1 and the second chip 2 in the present application.

It should be noted that, in this embodiment, as shown in FIG. 1, the conductive member may have an integral structure, and may also have a separate structure. That is, in this embodiment, when the conductive member has the integral structure, the conductive member is located at the transfer surface of the first chip 1 or the second chip 2. When the conductive member has the separate structure, a first part of the conductive member is located on the first chip 1, and a second part of the conductive member is located on the second chip 2. When the first chip 1 and the second chip 2 are interconnected, the first part of the conductive member and the second part of the conductive member are connected. In this embodiment, it is only necessary to ensure that the conductive member is connected between the pad of the second chip 2 and the pad of the first chip 1, so as to realize the interconnection and communication between the first chip 1 and the second chip 2. The structure of the conductive member is not further limited in this embodiment.

In this embodiment, as shown in FIG. 1, in order to make the leads used when interconnecting the first chip 1 and the second chip 2 as short as possible, the conductive member is vertically disposed between the pad of the second chip 2 and the pad of the first chip 1, so as to reduce the power dissipation when the first chip 1 and the second chip 2 are working, and realize the high speed communication between the first chip 1 and the second chip 2.

In this embodiment, the conductive member may be a cylinder, and may also be a prism or other structures, that is, in this embodiment, the conductive member includes but is not limited to the cylinder or the prism.

In this embodiment, the pad of the first chip 1 is disposed at the transfer surface of the first chip 1, and the pad of the second chip 2 is disposed at the transfer surface of the second chip 2. The pad of the first chip 1 and the corresponding pad of the second chip 2 are interconnected through one conductive component.

In this embodiment, the first chip 1 and the second chip 2 are both a single bare chip.

In this embodiment, the bare chip is a chip whose chip circuit has been fabricated on a wafer and cut from the wafer but has not been completely packaged. That is to say, both the first chip 1 and the second chip 2 that are interconnected are a single bare chip in this embodiment.

Specifically, compared with a flip-chip in the prior art, for which tin lead balls are deposited on pads of a chip, and then the chip is turned over and heated to combine with a ceramic substrate by utilizing the molten tin lead balls so as to form a flip-chip, in this embodiment, the two or more than two chips are interconnected through the conductive member, while the known flip-chip is connected to the ceramic substrate through solder. Therefore, the chip interconnection structure in this embodiment is different from the flip-chip in the body structure. In this embodiment, the interconnected single bare chips are disposed oppositely and connected through the conductive member, and the leads used when interconnecting the chips could be made to be shortest by vertically connecting the conductive member between the interconnected bare chips, thereby reducing length of the leads used when interconnecting the chips, and further realizing the high speed communication of the chips.

Specifically, for a chip-to-whole wafer butt welding process (referred to as CoW process) in the prior art, the CoW process is to face-down weld a single bare chip that has been cut onto a chip that has not been cut from a wafer by means of flip-chip, and finally realize a butt welding between the chip and the whole wafer by dispensing. The wafer in the CoW process has not been cut, so when the CoW process is used to realize the butt welding between the chip and the whole wafer, it is necessary to introduce proprietary equipment and proprietary materials, such as a wafer-level (that is, wafer-level) dispensing equipment and a thermal compression non-conductive paste (referred to as TCNCP) material, where the TCNCP is also called non-conductive thermosetting adhesive. Due to the introduction of the wafer-level dispensing equipment and the TCNCP, the cost of interconnecting the chip and the entire wafer will be greatly increased.

Compared with the CoW process in the prior art, since main functioning bodies of the chip interconnection structure in this embodiment are two or more single bare chips with each bare chip being a separate functional chip, in this embodiment, when the first chip 1 and the second chip 2 are interconnected, domestic conventional equipment can be used to achieve implementation of the interconnection of the chips, and to achieve the purpose of the high communication speed of the interconnected chips without introducing the wafer-level dispensing equipment and the TCNCP from foreign countries. Therefore, the chip interconnection structure in this embodiment has a lower production cost. It should be noted that, in this embodiment, the conventional equipment includes but is not limited to a chip-level dispensing equipment, and further includes other chip-level packaging equipment. Compared with the manner of achieving the interconnection between the chip and the whole wafer using the CoW process in the prior art, since main bodies of the interconnection in this embodiment are two or more single bare chips, the interconnection of the chips can be realized using the chip-level dispensing equipment and other chip-level packaging equipment. Therefore, the chip interconnection structure of this embodiment has a lower production cost than an interconnection structure of the chip and the wafer manufactured using the CoW process.

Therefore, this embodiment provides a chip interconnection structure, and the chip interconnection structure includes the first chip 1 and the at least one second chip 2. The transfer surface of the first chip 1 and the transfer surface of the second chip 2 are disposed oppositely, and the at least one conductive component is further provided between the second chip 2 and the first chip 1. Each conductive component includes at least one conductive member, and the conductive member is connected between the pad of the second chip 2 and the pad of the first chip 1. In the present application, the conductive member is connected between the pad of the first chip and the pad of the second chip, so that the leads used when interconnecting at least more than two chips are made to be shortest, thereby reducing the power dissipation when the chips are working, and further realizing the high speed communication of the chips. Therefore, the chip interconnection structure, chip, and interconnection method provided by the present application realize that two or more than two chips are interconnected, and can achieve the purpose of high speed communication of the interconnected chips.

### Embodiment 2

Further, on the basis of the embodiment described above, in this embodiment, as shown in FIG. 1 and FIG. 3, each conductive component includes at least two conductive members connected in sequence, and the pad of the first chip 1 and the pad of the second chip 2 are connected through two conductive members or two conductive members that are connected in sequence.

In this embodiment, as shown in FIG. 1 and FIG. 3, each conductive component includes a first conductive member 101 and a second conductive member 201. A first terminal of the first conductive member 101 is connected to the pad of the first chip 1; a second terminal of the first conductive member 101 and a first terminal of the second conductive member 201 are butted to each other; and a second terminal of the second conductive member 201 is connected to the pad of the second chip 2.

It should be noted that, the first conductive member 101 is connected to the pad of the first chip 1 and has an integral structure together with the pad of the first chip 1, and the second conductive member 201 is connected to the pad of the second chip 2 and has an integral structure together with the pad of the second chip 2. The first conductive member 101 and the second conductive member 201 connected in this embodiment are located on a same central axis, to shorten the leads used when interconnecting the first chip 1 and the second chip 2, reduce the power dissipation when the first chip 1 and the second chip 2 are working, and realize the high speed communication between the first chip 1 and the second chip 2.

In this embodiment, length, width, and height of the conductive members are all on a micron level, preferably 1-100um.

In this embodiment, when the conductive members are cylinders, diameters of the conductive columns are preferably 45 um, and heights of which are preferably 60 um.

In this embodiment, the conductive members are metal members, and the first conductive member 101 and the second conductive member 201 may be connected by welding. The welding manner includes hot pressing welding, reflow welding or ultrasonic welding, etc. In this embodiment, a welding manner suitable for materials of the conductive members is selected according to the materials specifically used for the conductive members.

In this embodiment, the materials of the conductive members are one or two of copper, silver, tin, gold and aluminum. That is, in this embodiment, materials of the first conductive member 101 and the second conductive member 201 may select the same material, and may also select different materials.

Specifically, in this embodiment, when the materials of the first conductive member 101 and the second conductive member 201 are the same, for example, when the materials of the first conductive member 101 and the second conductive member 201 are both tin, the second terminal of the first conductive member 101 and the first terminal of the second conductive member 201 are connected through butt welding relying on mutual fusion of tin and tin, preferably through reflow welding. When two materials from copper, silver, tin, gold and aluminum are selected for the first conductive member 101 and the second conductive member 201, a certain welding manner is adopted according to the selected materials.

Specifically, in this embodiment, the materials of the first conductive member 101 and the second conductive member 201 may be a combination of any two kinds of metal from copper, silver, tin, gold, and aluminum. The materials of the first conductive member 101 and the second conductive member 201 may also be any two kinds of conductive metal capable of forming eutectic among copper, silver, tin, gold and aluminum.

It should be noted that, in this embodiment, the materials of the first conductive member 101 and the second conductive member 201 are the conductive metal capable of forming the eutectic, and when the first conductive member 101 and the second conductive member 201 are welded to allow the first conductive member 101 and the second conductive member 201 to be electrically connected, a junction between the first conductive member 101 and the second conductive member 201 has an eutectic layer 4. Specifically, when the first conductive member 101 and the second conductive member 201 of this embodiment are the conductive metal capable of forming the eutectic, the first conductive member 101 and the second conductive member 201 may adopt tin and silver, tin and gold, gold and copper, gold and aluminum, and other combinations of the conductive metal that can form the eutectic. In this embodiment, when the first conductive member 101 and the second conductive member 201 may adopt tin and silver, the reflow welding is preferably used. When the first conductive member 101 and the second conductive member 201 may adopt tin and gold, or gold and copper, voltage welding is preferably used. When the first conductive member 101 and the second conductive member 201 may adopt gold and aluminum, ultrasonic welding is preferably used. That is, in this embodiment, the materials and the welding manner of the first conductive member 101 and the second conductive member 201 are not further limited.

Or, as shown in FIG. 2, the first conductive member 101 and the second conductive member 201 may also be connected through a conductive adhesive 5. Specifically, in this embodiment, the conductive adhesive 5 may be provided between the second terminal of the first conductive member 101 and the first terminal of the second conductive member 201, and an electrical connection between the first conductive member 101 and the second conductive member 201 is realized through the conductive adhesive 5. Specifically, in this embodiment, the electrical connection between the first conductive member 101 and the second conductive member 201 may be realized by providing a whole piece of conductive adhesive 5 between the first conductive member 101 and the second conductive member 201, and the electrical connection between the first conductive member 101 and the second conductive member 201 may also be realized by providing individual conductive adhesives 5 one by one at the second terminal of the first conductive member 101 or the first terminal of the second conductive member 201. When the first conductive member 101 and the second conductive member 201 are connected through the conductive adhesive 5, the materials of the first conductive member 101 and the second conductive member 201 may be one or two of copper, silver, tin, gold and aluminum.

Specifically, in this embodiment, when the electrical connection between the first conductive member 101 and the second conductive member 201 is realized by providing the whole piece of conductive adhesive 5 between the first conductive member 101 and the second conductive member 201, the whole piece of conductive adhesive 5 between the first conductive member 101 and the second conductive member 201 realizes the electrical connection between the first conductive member 101 and the second conductive member 201, meanwhile the whole piece of conductive adhesive 5 further forms a sealing layer 3 located between the first chip 1 and the second chip 2. The whole piece of conductive adhesive 5 in this embodiment may use a directional conductive adhesive with a directional conductive function, such as an anisotropic conductive film (Anisotropic Conductive Film, ACF), and conductive particles in the ACF between the first conductive member 101 and the second conductive member 201 are extruded and compressed by laminating, so as to realize the conductive communication between the first chip 1 and the second chip 2.

Specifically, in this embodiment, when the electrical connection between the first conductive member 101 and the second conductive member 201 is realized by providing the individual conductive adhesives 5 one by one at the second terminal of the first conductive member 101 or the first terminal of the second conductive member 201, the conductive adhesives between the first chip 1 and the second chip 2 are separate conductive adhesives 5, and the number thereof is equal to, and corresponds one-to-one to, the number of the first conductive member 101 or the second conductive member 201. The separate conductive adhesives 5 in this embodiment include but are not limited to a conductive adhesive containing silver particles, such as a conductive silver adhesive, through which the electrical connection between the first chip 1 and the second chip 2 is realized.

It should be noted that, when the electrical connection between the first conductive member 101 and the second conductive member 201 is realized by providing the individual conductive adhesives 5 one by one at the second terminal of the first conductive member 101 or the first terminal of the second conductive member 201, the sealing layer 3 in the embodiment of the present application still needs to be additionally provided between the first chip 1 and the second chip 2.

In this embodiment, the second terminal of the first conductive member 101 and the first terminal of the second conductive member 201 have the same projected shape, and the projected shape is a projected shape of the first conductive member 101 on the first chip 1, or a projected shape of the second conductive member 201 on the second chip 2. The projected shape may be a circle, an ellipse or a polygon.

### Embodiment 3

Further, on the basis of the embodiments described above, in this embodiment, as shown in FIG. 2, the number of the second chip 2 is at least two, and the second chips 2 are all disposed at the same side of the first chip 1, or the second chips 2 are disposed at front and back sides of the first chip 1.

It should be noted that, in this embodiment, as shown in FIG. 2, when the number of the second chip 2 is two or more than two, the second chips 2 may be disposed at the same side of the first chip 1, and all transfer surfaces of the second chips 2 are disposed oppositely to the transfer surface of the first chip 1, and are connected between pads of the first chip 1 and pads of the second chips 2 through conductive members. The second chips 2 may be disposed at the front and back sides of the first chip 1, that is, the second chips 2 may be evenly distributed at the front and back sides of the first chip 1. At this time, the front and back sides of the first chip 1 are both provided with a transfer surface, and the transfer surfaces of the first chip 1 are both provided with pads. The first chip 1 is located between the second chips 2, and the transfer surfaces of the first chip 1 and the transfer surfaces of the second chips 2 are disposed oppositely. By connecting between the pads of the first chip 1 and the pads of the second chips 2, the interconnection and communication between the first chip 1 and the second chip 2 are realized.

### Embodiment 4

Further, on the basis of the embodiments described above, as shown in FIG. 1, in this embodiment, the first chip 1 includes a first wafer 102; a first functional layer 103 is provided on the first wafer 102; a first pad 105 is provided (for example in an open hole manner) on the first functional layer 103, and may be configured to interconnect the first chip and other chips; a second pad 106 interconnected with other external circuits is further provided on the first functional layer 10. The number of the first pad 105 may vary according to different properties, such as the type and function of the first chip, and for example, there may be multiple first pads 105. Similarly, the number of the second pad 106 may also be multiple. The wafer in the present application may be a silicon wafer or other semiconductor wafers.

It should be noted that, in this embodiment, in order to facilitate interconnecting other external circuits and the first chip 1 through the second pads 106, the second pads 106 are located at outer sides of the first pads 105. The second pads 106 may be connected to other external circuits through a traditional wire bonding manner in the prior art, and may also be connected to other external circuits through the conductive members in the present application. In this embodiment, the manner of connecting the second pads 106 and other external circuits is not further limited.

In this embodiment, the second chip 2 includes a second wafer 202; a second functional layer 203 is provided on the second wafer 202; a third pad 205 is provided on the second functional layer 203; and the conductive member is connected between the third pad 205 and the first pad 105.

In this embodiment, all structures capable of implementing functions of the first chip 1 are provided inside the first functional layer 103. All the structures capable of implementing the functions of the first chip 1 include but are not limited to a metal layer and an active layer. The second functional layer 203 is similar to the first functional layer 103, and the first functional layer 103 and the second functional layer 203 are not further elaborated in this embodiment.

In this embodiment, when the transfer surface of the first chip 1 and the transfer surface of the second chip 2 are disposed oppositely, the first pad 105 and the third pad 205 are disposed oppositely, have equal numbers and correspond one-to-one to each other. The conductive member is connected between the third pad 205 and the first pad 105 to realize the interconnection and communication between the first chip 1 and the second chip 2.

It should be noted that, in this embodiment, the first conductive member 101 on the first chip 1 and the first pad 105 on the first chip 1 have equal numbers and correspond one-to-one to each other. Accordingly, the second conductive member 201 on the second chip 2 and the third pad 205 on the second chip 2 have equal numbers and correspond one-to-one to each other. The numbers of the first conductive member 101 and the second conductive member 201 are not further limited in this embodiment.

In this embodiment, the first chip 1 further includes a first insulating layer 104, and a first window structure 107 communicating with the first pad 105 is provided on the first insulating layer 104. The second chip 2 further includes a second insulating layer 204, and a second window structure 206 communicating with the third pad 205 is provided on the second insulating layer 204. The conductive member is located between the first window structure 107 and the second window structure 206.

It should be noted that, in this embodiment, the first window structure 107 is a window structure of the first insulating layer 104 processed on surfaces of the first pad 105 and the second pad 106 through a photolithography process or other processes on the first insulating layer 104 of the first chip 1. Accordingly, the second window structure 206 is a window structure of the second insulating layer 204 processed on a surface of the third pad 205 through the photolithography process or other processes on the second insulating layer 204 of the second chip 2. The first window structure 107 and the second window structure 206 may be pre-formed on the wafer where the first chip 1 is located and the wafer where the second chip 2 is located, respectively, or the first window structure 107 and the second window structure 206 may also be window structures formed later when interconnecting the chips. In this embodiment, a formation time of the first window structure 107 is not further limited.

In this embodiment, the insulating layers are used to realize surface insulation of the first chip 1 and the second chip 2 and have a certain protective effect for the first chip 1 and the second chip 2. In this embodiment, insulating materials used for the insulating layers may be an inorganic insulating material, such as polyimide, mica, and may also be an organic insulating material. In this embodiment, it is only necessary to ensure that the first insulating layer 104 and the second insulating layer 204 can realize the surface insulation of the first chip 1 and the second chip 2, respectively, and have the certain protective effect for the first chip 1 and the second chip 2. In this embodiment, the insulating material used for the first insulating layer 104 and the second insulating layer 204 is not further limited.

It should be noted that, thickness of the first insulating layer 104 and the second insulating layer 204 is on a micron level, such as 5um.

In this embodiment, the sealing layer 3 for sealing the conductive component is provided between the first chip 1 and the second chip 2, and an interconnection region of the first chip 1 and the second chip 2 is sealed and protected through the sealing layer 3.

In this embodiment, a sealing material used for the sealing layer 3 may be aqueous glue, and may also be epoxy glue or any other colloidal materials that can play roles of adhesion, anti-corrosion, and water vapor isolation.

### Embodiment 5

On the basis of the embodiments described above, this embodiment provides a chip, and the chip includes the chip interconnection structure described in any of the foregoing embodiments. The chip containing the chip interconnection structure in this embodiment may be used as a separate chip to perform subsequent processes, such as using a traditional packaging method for packaging usage, but this chip has functions of the first chip 1 and the second chip 2 at the same time.

### Embodiment 6

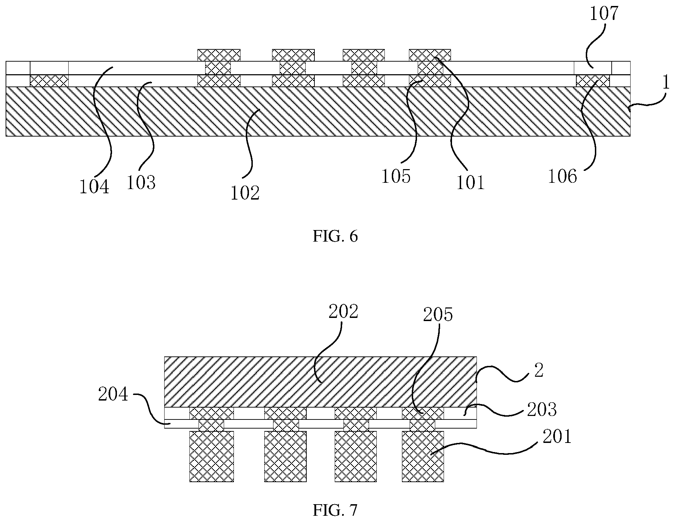

FIG. 3 is a schematic flowchart of an interconnection method according to Embodiment 6 of the present application; FIG. 4 is a schematic structural diagram of a first wafer according to Embodiment 6 of the present application; FIG. 5 is a schematic structural diagram of a second wafer according to Embodiment 6 of the present application; FIG. 6 is a schematic structural diagram of a first chip according to Embodiment 6 of the present application; and FIG. 7 is a schematic structural diagram of a second chip according to Embodiment 6 of the present application.

As shown in FIG. 3 to FIG. 7, on the basis of the embodiments described above, the present application provides a chip interconnection method which is applied to an interconnection between the first chip 1 and at least one second chip 2, and includes:
Step 101: forming a conductive member on at least one of the first wafer 102 and the second wafer 202, where the first wafer 102 is a wafer where the first chip 1 is located, the second wafer 202 is a wafer where the second chip 2 is located, and a position of the conductive member corresponds to a position of a pad;
Step 102: obtaining the first chip 1 and the second chip 2 on the first wafer 102 and the second wafer 202, respectively; and
Step 103: butting the first chip 1 and the second chip 2, and connecting a pad of the first chip 1 and a pad of the second chip 2 through the conductive member.

In this embodiment, the conductive member is formed on at least one of the first wafer 102 and the second wafer 202, that is, in this embodiment, the conductive member may be formed on the first wafer 102 or the second wafer 202, at this time, the conductive member has an integral structure; and the conductive member may also be formed on the first wafer 102 and the second wafer 202, respectively, at this time, the conductive member has a separate structure.

In this embodiment, the forming the conductive member on at least one of the first wafer 102 and the second wafer 202 specifically includes:
forming conductive members on the first wafer 102 and the second wafer 202, respectively.

It should be noted that, in this embodiment, as shown in FIG. 6 and FIG. 7, the conductive members are formed on the first wafer 102 and the second wafer 202, respectively. At this time, the conductive members include the first conductive member 101 and the second conductive member 201, the first terminal of the first conductive member 101 is connected to the pad of the first wafer 102, and the second terminal of the second conductive member 201 is connected to the pad of the second wafer 202.

In this embodiment, as shown in FIG. 6 and 7, the first conductive member 101 includes a first conductive part filled in the first window structure 107, and a second conductive part located at a surface of the first insulating layer 104. In order to increase contact area between the first conductive member 101 and the second conductive member 201, a projected area of the second conductive part on the first chip 1 is larger than a projected area of the first conductive part on the first chip 1. Accordingly, the second conductive member 202 also includes a third conductive part filled in the second window structure 206 and a fourth conductive part located at a surface of the second insulating layer 204. Similarly, in order to increase contact area between the first conductive member 101 and the second conductive member 201, a projected area of the fourth conductive part on the second chip 2 is larger than a projected area of the third conductive part on the second chip 2.

It should be understood that, as shown in FIG. 1 and FIG. 2, when the first chip 1 and the second chip 2 are interconnected through the first conductive member 101 and the second conductive member 201, the second conductive part of the first conductive member 101 is in contact with the fourth conductive part of the second conductive member 202.

In this embodiment, the second terminal of the first conductive member 101 and the first terminal of the second conductive member 201 have the same projected shape, and the projected shape is a projected shape of the first conductive member 101 on the first chip 1, or a projected shape of the second conductive member 201 on the second chip 2. The projected shape may be a circle, an ellipse or a polygon.

In this embodiment, a formation manner of the conductive members includes one or more of the following: sputtering, evaporating, electroplating, electroless-plating, and pasting a conductive film.

In this embodiment, specifically, when the conductive members are formed by sputtering, a seed layer of Ti and Wu is first sputtered on an entire surface of the first insulating layer 104 or the second insulating layer 204, photoresist is coated, bumps and pits required by the conductive members are processed through a photolithography process, gold is electroplated to fully fill the pits, and the seed layer is etched after removing the photoresist to obtain a desired structure. It should be noted that, forming the conductive members on the insulating layers of the wafers by means of sputtering, evaporating, electroplating, electroless-plating, and pasting a conductive film is as in the prior art. The specific formation process of the conductive members will not be further elaborated in this embodiment.

In this embodiment, the obtaining the first chip 1 and the second chip 2 on the first wafer 102 and the second wafer 202, respectively, specifically includes:
cutting out the first chip 1 from the first wafer 102, and cutting out the second chip 2 from the second wafer 202, where the first chip 1 and the second chip 2 are both a single bare chip.

In this embodiment, before the cutting, the first wafer 102 and the second wafer 202 firstly need to be grinded and thinned, so as to be grinded to specified thickness of the chips, and then the first chip 1 and the second chip 2 are cut out from the first wafer 102 and the second wafer 202. Therefore, in this embodiment, both the first chip 1 and the second chip 2 are a single bare chip.

In this embodiment, the connecting the pad of the first chip 1 and the pad of the second chip 2 using the conductive member specifically includes:
connecting the conductive member on the first chip 1 and/or the conductive member on the second chip 2 by welding or laminating, so that the conductive member connects the pad of the first chip 1 and the pad of the second chip 2.

In this embodiment, the process used when interconnecting the first chip 1 and the second chip 2 varies according to the material selected for the conductive member. The material of the conductive member and the connection manners corresponding to different materials have been illustrated in the foregoing embodiments, which will not be further elaborated in this embodiment.

In this embodiment, the conductive adhesive 5 may be provided between the first conductive member 101 and the second conductive member 201, to realize an electrical connection between the first conductive member 101 and the second conductive member 201 through the second chip 2. Specifically, in this embodiment, the electrical connection between the first conductive member 101 and the second conductive member 201 may be realized by providing a whole piece of conductive adhesive 5 between the first conductive member 101 and the second conductive member 201, and the electrical connection between the first conductive member 101 and the second conductive member 201 may also be realized by providing individual conductive adhesives 5 one by one at the second terminal of the first conductive member 101 or the first terminal of the second conductive member 201.

In this embodiment, as shown in FIG. 4 and FIG. 5, before the step of forming the conductive member on at least one of the first wafer 102 and the second wafer 202, the method further includes:
determining whether there is an insulating layer on surfaces of both the first wafer 102 and the second wafer 202;
if there are insulating layers on the surfaces of the first wafer 102 and the second wafer 202, providing the first window structure 107 communicating with the pad of the first wafer 102 on the insulating layer of the first wafer 102, and providing the second window structure 206 communicating with the pad of the second wafer 202 on the insulating layer of the second wafer 202; and
if there is no insulating layer on the surfaces of the first wafer 102 and the second wafer 202, forming the insulating layers on the surfaces of the first wafer 102 and the second wafer 202, respectively, providing the first window structure 107 communicating with the pad of the first wafer 102 on the insulating layer of the first wafer 102, and providing the second window structure 206 communicating with the pad of the second wafer 202 on the insulating layer of the second wafer 202.

It should be noted that, as shown in FIG. 4 and FIG. 5, the first window structure 107 is formed on the first insulating layer 104 of the first chip 1, and the second window structure 206 is formed on the second insulating layer 204 of the second chip 2. The manner of forming the insulating layers on the surfaces of the first wafer 102 and the second wafer 202 includes processes such as even colloid coating, plasma spraying, printing, conductive adhesive 5 and film pasting, etc. Forming the insulating layers through the above processes is as in the prior art, which will not be further elaborated in this embodiment.

In this embodiment, after connecting the pad of the first chip 1 and the pad of the second chip 2 using the conductive member, the method further includes:
forming the sealing layer 3 for sealing the conductive component between the first chip 1 and the second chip 2, and sealing and protecting an interconnection region of the first chip 1 and the second chip 2 through the sealing layer 3.

It should be noted that, the formation manner of the sealing layer 3 includes any colloid forming process such as dispensing, scribing, and molding, etc. Forming the sealing layer through the above colloid forming processes is as in the prior art, which will not be further elaborated in this embodiment.

It should be noted that, when the electrical connection between the first conductive member 101 and the second conductive member 201 is realized by providing the whole piece of conductive adhesive 5 between the first conductive member 101 and the second conductive member 201, the whole piece of conductive adhesive 5 between the first conductive member 101 and the second conductive member 201 realizes the electrical connection between the first conductive member 101 and the second conductive member 201, meanwhile the whole piece of conductive adhesive 5 further forms the sealing layer 3 located between the first chip 1 and the second chip 2 in this embodiment.

The chip interconnection structure, chip and interconnection method provided by the present application realize the interconnections of two or more than two chips, and can achieve the purpose of high speed communication of the interconnected chips.

In the description of the present application, it should be understood that, the orientation or positional relationship indicated by the terms "center", "longitudinal", "transverse", "length", "width", "thickness", "upper", "lower", "front", "back", "left", "right", "vertical", "horizontal", "top", "bottom", "inner", and "outer" and the like are based on the orientation or positional relationship shown in the drawings, which are only for convenience of describing the present application and simplifying the description, rather than indicating or implying that the apparatus or member referred to must have a specific orientation, be constructed and operated in a specific orientation, and therefore cannot be understood as limitation of the present application.

In the description of the present application, it should be understood that, the terms "including" and "having" and any variations thereof used herein are intended to cover non-exclusive inclusions, for example, processes, methods, systems, products or devices that comprise a series of steps or units are not necessarily limited to those steps or units clearly listed, but may include other steps or units that are not clearly listed or are inherent to these processes, methods, products, or devices.

Unless otherwise clearly specified and limited, the terms "installation", "interconnected", "connected", "fixed" and the like should be understood in a broad sense, for example, they may be a fixed connection, and may also be a detachable connection, or be integral; they may be a direct connection, and may also be an indirect connection through an intermediate medium, may be an internal communication between two elements or an interactive relationship between the two elements. For those of ordinary skill in the art, the specific meanings of the above terms in the present application may be understood according to specific circumstances. In addition, the terms "first", "second", and the like are only used for descriptive purposes, and cannot be understood as indicating or implying relative importance or implicitly indicating the number of indicated technical features.

Finally, it should be noted that the above embodiments are merely intended for describing, rather than limiting, the technical solutions of the present application; although the present application has been described in detail with reference to the foregoing embodiments, those skilled in the art will understand that they may still make modifications to the technical solutions described in the foregoing embodiments, or make equivalent substitutions to some or all of the technical features therein; and the modifications or substitutions do not make the essence of the corresponding technical solutions deviate from the scope of the technical solutions in the embodiments of the present application.

## Claims

1. A chip interconnection structure, comprising a first chip and at least one second chip, wherein a transfer surface of the first chip and a transfer surface of the second chip are disposed oppositely, at least one conductive component is further provided between the second chip and the first chip, each conductive component comprises at least one conductive member, and the conductive member is connected between a pad of the second chip and a pad of the first chip.

2. The chip interconnection structure according to claim 1, wherein each conductive component comprises at least two conductive members connected in sequence.

3. The chip interconnection structure according to claim 2, wherein the at least two conductive members connected in sequence are stacked.

4. The chip interconnection structure according to claim 1, wherein each conductive component comprises a first conductive member and a second conductive member, a first terminal of the first conductive member is connected to the pad of the first chip, a second terminal of the first conductive member and a first terminal of the second conductive member are butted to each other, and a second terminal of the second conductive member is connected to the pad of the second chip.

5. The chip interconnection structure according to claim 4, wherein the conductive member is a metal member.

6. The chip interconnection structure according to claim 4 or 5, wherein the first conductive member and the second conductive member are connected through welding, or the first conductive member and the second conductive member are connected through conductive adhesive.

7. The chip interconnection structure according to claim 4 or 5, wherein a material of the conductive member is one or two of copper, silver, tin, gold and aluminum.

8. The chip interconnection structure according to claim 5, wherein the first conductive member and the second conductive member are conductive metal capable of forming eutectic.

9. The chip interconnection structure according to claim 5, wherein when the first conductive member and the second conductive member are connected through welding, a junction between the first conductive member and the second conductive member has a eutectic layer.

10. The chip interconnection structure according to any one of claims 1 to 9, wherein the conductive member and the pad have an integral structure.

11. The chip interconnection structure according to claim 4, wherein the second terminal of the first conductive member and the first terminal of the second conductive member have a same cross-section shape.

12. The chip interconnection structure according to claim 11, wherein the conductive member is vertically disposed between the pad of the second chip and the pad of the first chip.

13. The chip interconnection structure according to claim 11 or 12, wherein the conductive member is a cylinder or a prism.

14. The chip interconnection structure according to claim 1, wherein the number of the second chip is at least two, and the second chips are disposed at a same side of the first chip, or the second chips are disposed at front and back sides of the first chip.

15. The chip interconnection structure according to any one of claims 1 to 9, wherein the first chip and the second chip are both a single bare chip.

16. The chip interconnection structure according to claim 15, wherein the first chip comprises a first wafer, a first functional layer is provided on the first wafer, a first pad is provided on the first functional layer, and a second pad interconnected with an external circuit is further provided on the first functional layer; and
the second chip comprises a second wafer, a second functional layer is provided on the second wafer, a third pad is provided on the second functional layer, and the conductive member is connected between the third pad and the first pad.

17. The chip interconnection structure according to claim 16, wherein the first chip further comprises a first insulating layer, a first window structure communicating with the first pad is provided on the first insulating layer; the second chip further includes a second insulating layer, a second window structure communicating with the third pad is provided on the second insulating layer; and the conductive member is located between the first window structure and the second window structure.

18. The chip interconnection structure according to claim 17, wherein a sealing layer for sealing the conductive component is further provided between the first chip and the second chip.

19. The chip interconnection structure according to claim 1, wherein the pad of the first chip is disposed on the transfer surface of the first chip, the pad of the second chip is disposed on the transfer surface of the second chip, and the pad of the first chip and the corresponding pad of the second chip are interconnected through the one conductive component.

20. A chip, comprising the chip interconnection structure according to any one of claims 1 to 19.

21. A chip interconnection method, applied to an interconnection of a first chip and at least one second chip, comprising:
forming a conductive member on at least one of a first wafer and a second wafer, wherein the first wafer is a wafer where the first chip is located, the second wafer is a wafer where the second chip is located, and a position of the conductive member corresponds to a position of a pad;
obtaining the first chip and the second chip on the first wafer and the second wafer, respectively; and
butting the first chip and the second chip, and connecting a pad of the first chip and a pad of the second chip using the conductive member.

22. The chip interconnection method according to claim 21, wherein the forming the conductive member on the at least one of the first wafer and the second wafer specifically comprises:
forming conductive members on the first wafer and the second wafer, respectively.

23. The chip interconnection method according to claim 21 or 22, wherein a formation manner of the conductive member comprises one or more of the following: sputtering, evaporating, electroplating, electroless-plating, and pasting a conductive film.

24. The chip interconnection method according to claim 21, wherein the obtaining the first chip and the second chip on the first wafer and the second wafer, respectively, specifically comprises:
cutting out the first chip from the first wafer, and cutting out the second chip from the second wafer, wherein the first chip and the second chip are both a single bare chip.

25. The chip interconnection method according to claim 21, wherein the connecting the pad of the first chip and the pad of the second chip using the conductive member specifically comprises:
connecting the conductive member on the first chip and/or the conductive member on the second chip by welding or laminating, so that the conductive member connects the pad of the first chip and the pad of the second chip.

26. The chip interconnection method according to claim 21, before the step of forming the conductive member on the at least one of the first wafer and the second wafer, further comprising:
if there are insulating layers on surfaces of the first wafer and the second wafer, providing a first window structure communicating with the pad of the first wafer on an insulating layer of the first wafer, and providing a second window structure communicating with the pad of the second wafer on an insulating layer of the second wafer; and
if there is no insulating layer on the surfaces of the first wafer and the second wafer, forming the insulating layers on the surfaces of the first wafer and the second wafer, respectively, providing the first window structure communicating with the pad of the first wafer on the insulating layer of the first wafer, and providing the second window structure communicating with the pad of the second wafer on the insulating layer of the second wafer.

27. The chip interconnection method according to claim 21, after connecting the pad of the first chip and the pad of the second chip using the conductive member, further comprising:
forming a sealing layer between the first chip and the second chip.
